(19) **Europäisches Patentamt / European Patent Office / Office européen des brevets**

(11) **EP 1 296 145 B1**

(12) **EUROPEAN PATENT SPECIFICATION**

(45) Date of publication and mention
of the grant of the patent:
**11.04.2007 Bulletin 2007/15**

(51) Int Cl.:
*G01R 1/067* (2006.01)     *H01L 21/66* (2006.01)
*H01R 13/24* (2006.01)     *H01R 33/76* (2006.01)

(21) Application number: **01943857.1**

(86) International application number:
**PCT/JP2001/005555**

(22) Date of filing: **28.06.2001**

(87) International publication number:
**WO 2002/001232 (03.01.2002 Gazette 2002/01)**

(54) **CONDUCTIVE CONTACT**

LEITENDER KONTAKT

CONTACT CONDUCTEUR

(84) Designated Contracting States:
**DE FR IT**

(30) Priority: **28.06.2000 JP 2000194511**

(43) Date of publication of application:
**26.03.2003 Bulletin 2003/13**

(73) Proprietor: **NHK SPRING CO., LTD.**
**Yokohama-shi, Kanagawa 236-0004 (JP)**

(72) Inventor: **KAZAMA, Toshio**
**Kamiina-gun, Nagano 399-4301 (JP)**

(74) Representative: **Weydert, Robert et al**
**Dennemeyer & Associates Sàrl**
**P.O. Box 1502**
**1015 Luxembourg (LU)**

(56) References cited:
WO-A-98/29751     JP-A- 7 321 169
JP-A- 8 115 955     JP-A- 9 232 057
JP-A- 11 160 355     JP-U- 7 019 984

• **PATENT ABSTRACTS OF JAPAN vol. 2000, no. 08, 6 October 2000 (2000-10-06) & JP 2000 137042 A (JAPAN ELECTRONIC MATERIALS CORP), 16 May 2000 (2000-05-16)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European Patent Convention).

**Description**

TECHNICAL FIELD

The present invention relates to a conductive contact member suitable for testing and other applications in the field of semiconductor devices.

BACKGROUND OF THE INVENTION

Conventionally, various forms of conductive contact members have been used in electrically testing (open/short circuit tests, environmental tests, burn-in tests and so forth) electroconductive patterns of printed circuit boards and electronic components, and in contact probes for testing wafers and electric connectors.

In such a conductive contact member, when the contact part of the object to be tested (such as a terminal of a semiconductor device) is made of solder or covered by solder, repeated application of the conductive contact member onto such terminals causes a deposition of solder on the tip of the conductive contact member which may be in the form of a needle member or a coil.

As disclosed in WO 98/29751, on which the two-part form of independent claim 1 is based, the conductive contact member may have a gold plated surface or the like (such as a rhodium plating) to allow for easy removal of solder debris deposited on the non-conductive contact member.

It has also been proposed to provide a conductive contact member which is surface processed by gold plating (which is added with 0.3 to 4% of cobalt, for instance) to ensure stable electric properties and a low electric resistance. However, as such a solder deposition progresses, the electric resistance in the electric path of the conductive contact member deviates from the expected range, and the accuracy of the test may be impaired. Therefore, it was necessary to replace the conductive contact member before the accuracy of the test drops below a prescribed level. As a result, the conductive contact member had to be replaced for cleaning so frequently that the efficiency of the test line was impaired, and the maintenance cost increased.

BRIEF SUMMARY OF THE INVENTION

To eliminate such problems of the prior art, a primary object of the present invention is to provide a conductive contact member which is required to be replaced due to solder deposition less frequently than the conventional conductive contact member.

A second object of the present invention is to provide a conductive contact member which demonstrates a low electric resistance over a prolonged period of time, and thereby provides a longer service life than the conventional conductive contact member.

A third object of the present invention is to provide a conductive contact member having a contact portion which is resistant to solder deposition.

According to the present invention, these objects can be accomplished by providing a conductive contact member for establishing an electric contact by being applied to an object to be contacted, comprising a layer of highly electrically conductive material resistant to solder deposition formed at least over a conductive contact part of the conductive contact member, characterized in that the highly electrically conductive material consists of gold added with 0.01 % to 8 % silver. The layer of highly electrically conductive material may be formed preferably by electroplating, but also by other processes which include, not exclusively, electroless plating, sputtering, PVD, CVD and thermal spraying. The conductive contact member may be in the form of a coil spring or needle member or rod member which may have either a pointed end or flat end.

Thus, owing to such resistance to solder deposition, the deposition of solder to the conductive contact part is minimized even when it is repeatedly applied to objects to be contacted, and the frequency of replacing the conductive contact part can be reduced. Also, although the base material for the conductive contact member may consist of inexpensive material having favorable mechanical properties such as steel, the conductive contact member can continue to demonstrate a low electric resistance even after a large number of test cycles or a long service period in a stable manner.

BRIEF DESCRIPTION OF THE DRAWINGS

Now the present invention is described in the following with reference to the appended drawings, in which:

Figure 1 is a vertical sectional view of an electric contact probe head using a conductive contact member in the form of a coil spring embodying the present invention;
Figure 2 is a partly broken away perspective view of a coil wire on which a gold plate layer added with silver is formed;
Figure 3 is a partly broken away perspective view of the coil wire of Figure 2 after it has been coiled;
Figure 4 is a partly broken away perspective view showing the assembly of Figure 3 after a second gold plate layer added with silver is formed thereon;
Figure 5 is a view similar to Figure 1 showing the operative state of the contact probe head;
Figure 6 is a view similar to Figure 1 showing a second embodiment of the present invention;
Figure 7 is an enlarged sectional view showing the state of the head of the conductive contact member having gold plating added with silver formed thereon;
Figure 8 is a view similar to Figure 5 showing the operative state of the contact probe head of Figure 6;
Figure 9 is a view similar to Figure 7 showing a modified embodiment of the contact probe head having a flat end;

Figure 10 is a view similar to Figure 1 showing a third embodiment of the present invention;

Figure 11 is a view similar to Figure 1 showing a fourth embodiment of the present invention;

Figure 12 is a view similar to Figure 1 showing a fifth embodiment of the present invention; and

Figure 13 is a view similar to Figure 1 showing a sixth embodiment of the present invention.

DETAILED DESCRIPTION OF THE PREFERRED EMBODIMENTS

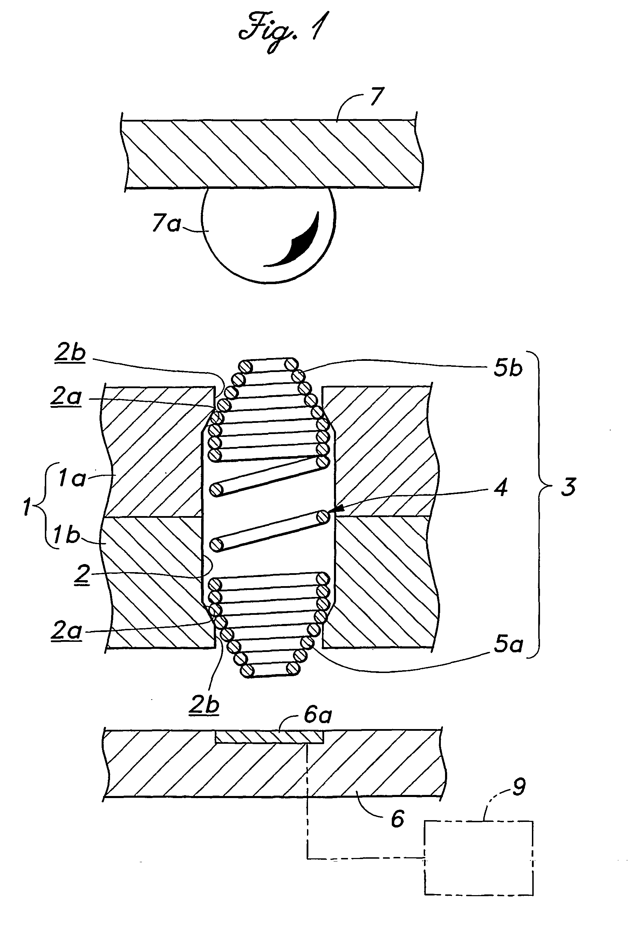

Figure 1 is an enlarged sectional side view of an essential part of a conductive contact member 3 used in a contact probe head for contacting semiconductor devices embodying the present invention. In the illustrated conductive probe head, an electrically insulating holder 1 is formed by a pair of plastic insulating plate members 1a and 1b placed closely one over the other in an integral manner, and through holes 2 (only one of them is shown in the drawing) are passed across the thickness of the holder 1. A conductive contact member 3 in the form of a coil spring is coaxially received in each of the through holes 2.

The through hole 2 is provided with a straight main section having a constant diameter and a prescribed length at an axially intermediate part thereof, and a pair of tapered sections 2a each having a narrower end opening toward the upper or lower end of the holder 1 as seen in the drawing. The narrowed open end of each tapered section 2a communicates with the exterior of the through hole 2 via a small diameter section 2b having a constant small diameter and a prescribed length.

The conductive contact member 3 in the form of a coil spring is formed by winding a wire made of spring material such as steel into a coil, and comprises a coil spring section 4 wound at a prescribed pitch and received in the straight section formed in the intermediate part of the through hole 2 with a certain radial play, and a pair of electrode pin sections 5a and 5b serving as conductive contact parts. Each electrode pin section 5a, 5b consists of a plurality of turns of the coil wire extending from the coil spring section 4 and having the same diameter as the coil spring section 4, and a closely would tapered section extending therefrom to a coil end. The tapered section of each electrode pin section 5a, 5b is substantially complementary in shape to the tapered section 2a of the through hole 2, and has an outer end which has a smaller diameter than the inner diameter of the small diameter section 2b so as to be able to project outwardly out of the small diameter section 2b.

The conductive contact member 3 in the form of a coil spring is received in the through hole 2 with the coil spring section 4 compressed. For instance, the insulating plate members 1a and 1b are placed one over the other with the electrode pin sections 5a and 5b received in the corresponding parts of the through hole 2 so that the conductive contact member 3 in the form of a coil spring is assembled into the insulating plate 3 with a certain pre-stress applied to the coil spring section 4.

Because the electrode pin sections 5a and 5b are tapered, in the work step of placing the two insulating plate members 1a and 1b one over the other, the outer ends of the electrode pin sections 5a and 5b are each guided by and into the corresponding tapered section 2a of the through hole 2 simply by placing the outer end of the electrode pin section 5a, 5b in the opposing open ends of the through hole 2. Therefore, the assembly work is substantially simplified as compared to the case of a conductive contact member in the form of a needle member which is required to be passed into a support hole without any such guiding action during the assembly process.

As the two insulating plate members 1a and 1b are securely and closely fixed to each other by using threaded bolts or the like, the resilient force of the coil spring section 4 causes each tapered electrode pin section 5a, 5b to abut the complementary tapered surface of the corresponding tapered section 2a of the through hole 2 so that the conductive contact member 3 is prevented from being dislodged from the through hole 2 while the variations in the lateral position of the tip of each conductive contact member 3 is minimized. Therefore, when a plurality of such conductive contact members 3 are arranged in a matrix according to the number and distribution of the points to be tested, the positional accuracy of the projecting end of each conductive contact member in a Cartesian coordinate system can be ensured simply and automatically by assembling the conductive contact members 3 into the support holes 2 of the holder 1.

Thus, the tip of each electrode pin section 5a, 5b of each conductive contact member 3 projects out of the corresponding through hole 2 by a prescribed length under a rest condition. Such a conductive contact member 3 can be used, in a contact probe for instance, to contact a terminal of a semiconductor device such as a solder ball 7a of a BGA7.

By applying a preload to the conductive contact member 3 in the form of a coil spring, it becomes possible to minimize the variations in the contact load due to the variations in the deflection stroke arising from the variations in the elevation of the object to be contacted (such as the circuit pattern 6a and terminal 7a) to which the conductive contact member 3 is applied.

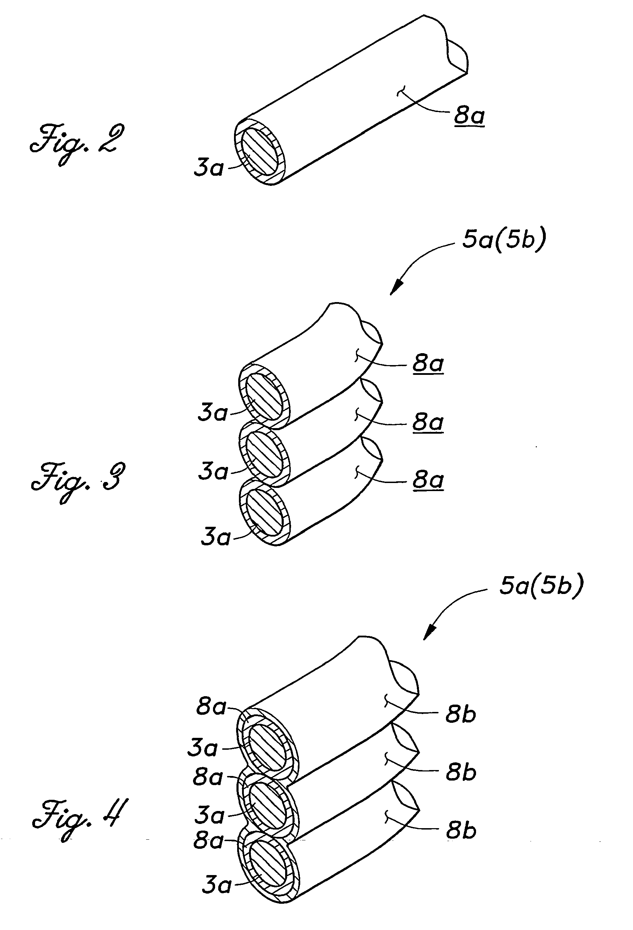

Figures 2 to 4 show the mode of forming the conductive contact member 3 in the form of a coil spring according to the present invention. First of all, gold added with 0.01% to 8% of silver is plated over the surface of a coil wire 3a made of spring material such as steel as mentioned earlier as a surface process of forming a highly electroconductive layer, and a gold plate layer 8a added with silver is thereby formed over the entire outer surface of the coil wire 3a as illustrated in Figure 2.

The gold-plated coil wire 3a is then subjected to a coiling process, and the coil spring section 4 and electrode pin sections 5a and 5b as illustrated in Figure 1 are formed. The coil wire 3a is closely wound in the electrode pin sections 5a and 5b as illustrated in Figure 3, and is additionally given with a pre-stress so that the adjacent turns of the coil wire 3a of the electrode pin sections 5a and 5b are pressed against one another. As a result, in the electrode pin sections 5a and 5b, the axially opposing gold plate layers 8a added with silver each abut one another with a certain preload.

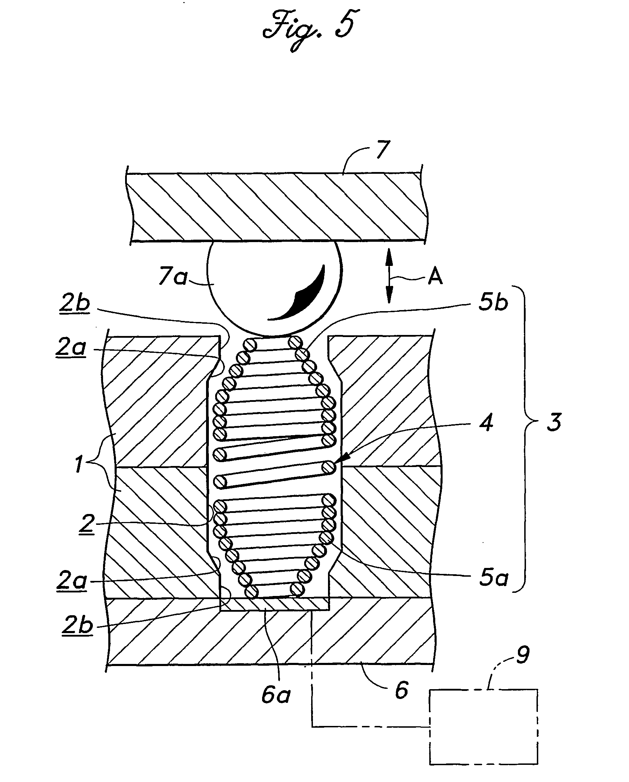

Then, as shown in Figure 4, gold added with silver is plated over the outer surface of the conductive contact member 3 in the state illustrated in Figure 3 to form a second gold plate layer 8b added with silver over the entire outer circumference of the closely wound section. As a result, the adjacent turns of the coil wire 3a is bonded to each other by the second gold plate layer 8b added with silver formed continually along the axial direction, in addition to being subjected to a mechanical force urging them toward each other. Therefore, the close contact between the adjacent turns of the coil wire 3a is even more enhanced, and the contact resistance between the adjacent turns is reduced even further. As far as the electric current which flows through the second gold plate layer 8b added with silver is concerned, there is no contact resistance.

In the embodiment illustrated in Figures 2 to 4, the gold plate layer 8a added with silver was formed on the coil wire 3a before it is coiled. However, it is also possible to coil the coil wire 3a without plating, and then form a gold plate layer added with silver (similar to the second gold plate layer 8b added with silver) over the entire surface. At any event, the material for the coil wire 3a can be freely selected without regard to its electric conductivity, and may consist of materials such as spring material which have favorably mechanical properties and are inexpensive.

The mode of operation of the conductive contact member 3 in the form of a coil spring which is manufactured as described above is illustrated in Figure 5. In this case, because the electric signal is conducted solely through the conductive contact member 3 in the form of a coil spring, and there is no soldered part or other connected part between the circuit board 6 and the BGA 7, the electric resistance of the conductive path is highly stabilized. The coil spring section 4 is necessary for resiliently applying the conductive contact member 3 onto the object to be contacted. The number of turns N of the coil spring is related the electric inductance H thereof according to the equation given below.

$$H = AN^2/L$$

where A is a coefficient, and L is the length of the coil spring. Therefore, for minimizing the inductance, it is essential to reduce N as much as possible. To this end, it is desired that the number of turn is 10 or less, but, more preferably, two or less as is the case with the illustrated embodiment.

Because each electrode pin section 5a, 5b is closely wound, and generally covered by the second gold plate layer 8b added with silver in axially continuous manner, the electric conductive path in the electrode pin section extends in the axial direction of the coil spring. Therefore, even though the coil wire is turned into a coil, the electric current does not flow along a spiral path, and this contributes to the reduction in the electric resistance and inductance.

Because the straight small diameter section 2b is formed between the outer end of the tapered section 2a of the through hole 2 and the exterior of the through hole 2, the tip of the tapered electrode pin section 5a, 5b is prevented from being caught by this part of the through hole 2. Also, because the provision of the straight small diameter section 2b ensures a substantial wall thickness to the peripheral part of the opening, the peripheral part of the open end of the straight small diameter section 2b is prevented from being damaged by an inadvertent contact with a terminal consisting of a solder ball 7a or the like.

When testing a semiconductor device such as a BGA 7 by using such a conductive contact member, the electrode pin section 5a is repeatedly brought into contact with a number of BGAs 7 conveyed along a test line one by one as indicated by the arrow A in Figure 5. As a result of such repeated contacts with terminals 7a, a small portion of the solder on each terminal deposits on the electrode pin section 5a, and the amount of deposition increases with the number of contacts.

According to the present invention, because a gold plating added with silver is applied to the electrode pin section 5a as discussed above, the deposition of solder can be substantially reduced as compared with the conventional gold plating added with cobalt (0.3% to 4%). For instance, whereas the conventional conductive contact member was required to be replaced after about 3,000 test cycles, the conductive contact member according to the present invention was able to withstand more than 20,000 test cycles.

Although the conductive contact member of the present invention was applied to a contact probe head in the foregoing embodiment, the conductive contact member of the present invention can also be used as electric sockets for semiconductor devices. In this case, the possible number of reuse of the socket can be substantially increased, and the durability of the socket can be enhanced.

The conductive contact member according to the present invention is not limited to the conductive contact member 3 in the form of a coil spring, but may also consist of a conductive needle member 14 for a contact probe head 11. Such a conductive contact member 14 is described in the following.

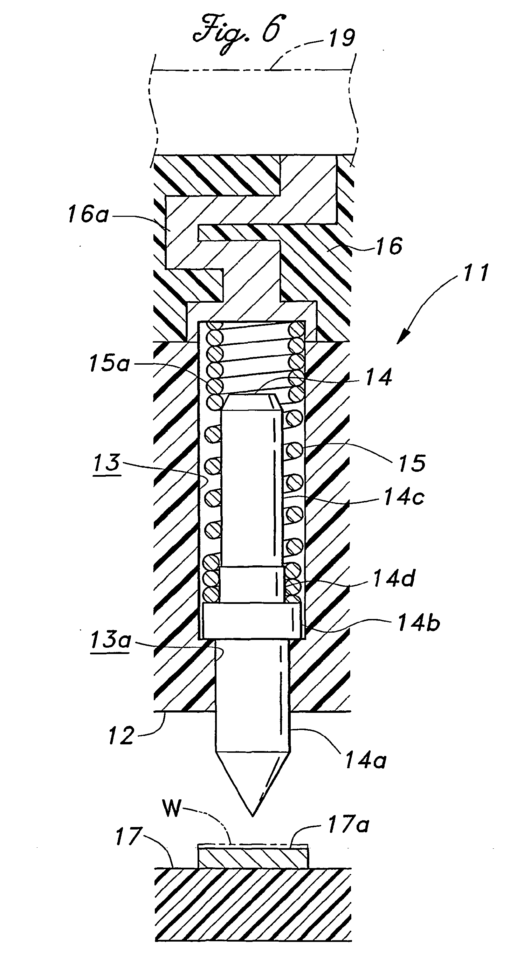

Figure 6 is a schematic longitudinal sectional view of a contact probe head 11 employing the conductive contact member 14 embodying the present invention. The object to be tested typically includes a plurality of points to be contacted that need to be accessed simultaneously, and a large number of such conductive contact members 14 are arranged in parallel to one another. It can be also used as a sole conductive contact member 14 in a contact probe.

A holder is formed by passing a support hole 13 across the thickness of an insulating plate member 12, and a conductive needle member 14 is coaxially received in the support hole 13. A compression coil spring 15 resiliently urges the conductive needle member 14 outwardly out of the support hole 13. On the upper end of the plate member 12 as seen in the drawing is layered a relay board 16 serving as signal exchanging means, and an electroconductive path 16a is formed integrally with the relay board 16 to conduct an electric signal across the thickness of the relay board 16.

A test circuit board 19 is typically placed over the relay board 16 when the conductive contact member 14 is put to an actual use. Thus, by preparing different relay boards corresponding to the various circuit patterns and terminal layouts of different objects to be tested, the contact probe head can be readily adapted to different layout patterns of the object to be contacted.

The conductive needle member 14 comprises a head 14a having a pointed end and adapted to contact an object to be contacted, a large diameter portion 14b provided on the inner end of the head 14a, and a stem portion 14c extending from the inner end of the large diameter portion 14b to the inner most end, all in a coaxial relationship. The support hole 13 receives the large diameter portion 14b of the conductive needle member 14 and the compression coil spring 15 coaxially wound around the stem portion 14c. The support hole 13 is provided with a small diameter portion 13a at an end facing away from the relay board 16 for axially slidably supporting only the head 14a, and a shoulder defined by the small diameter portion 13a of the support hole 13 engages the large diameter portion 14b to retain the conductive needle member 14 in the support hole 13.

In the illustrated embodiment, the projecting end of the head 14a consists of a pointed end so that an accurate contact may be established even when a small pad is required to be contacted. The terminal end of the head 14a may also take other forms depending on the shapes of the objects to be contacted, and may be provided with a flat end, instead of a pointed end, to be adapted to contact a solder ball, for instance.

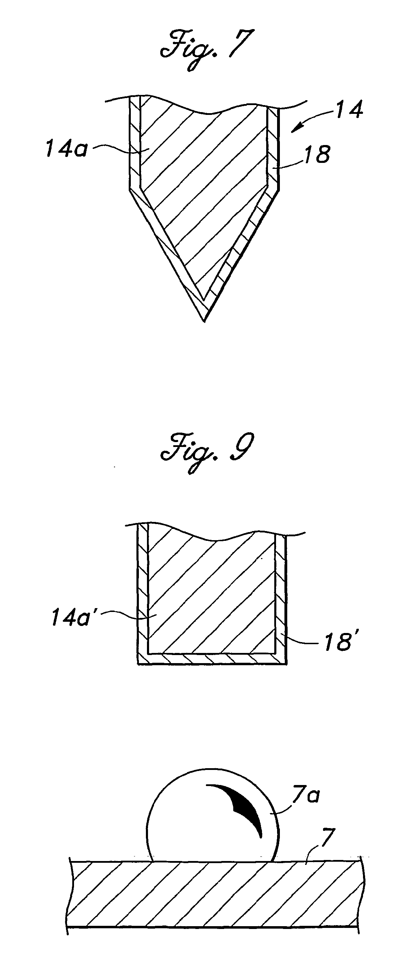

A gold plating added with 0.5% to 8% of silver is applied to the head 14a of the conductive needle member 14 in a similar manner as the previous embodiment so as to form a gold plate layer 18 added with silver as illustrated in Figure 7. Thus, the deposition of solder onto the conductive needle member 14 can be substantially reduced when contacting objects to be contacted, and the advantages mentioned above can be gained.

The compression coil spring 15 wound around the stem portion 14c is assembled in a pre-compressed state between the large diameter portion 14b and relay board 16. In the illustrated embodiment, a slightly enlarged boss portion 14d having a slightly larger outer diameter than the inner diameter of the compression coil spring 15 is formed in the part of the stem portion 14c adjacent to the large diameter portion 14b so that the coil end of the compression coil spring 15 may be resiliently wrapped around the boss portion 14d. Therefore, the compression coil spring 15 can be integrally combined with the conductive needle member 14 prior to placing the conductive needle member 14 in the support hole 13, and this simplifies the assembling process. The compression coil spring 15 can be joined with the boss portion 14d by resiliently wrapping around it as is the case with the illustrated embodiment, but may also be soldered to the boss portion to achieve a similar joining action. Also, a simple fitting engagement may be adequate if the required contact pressure can be achieved.

The compression coil spring 15 is provided with a closely wound section 15a which remains in a closely wound state under the rest condition at an end facing the relay board 16 or the end corresponding to the retracting direction of the conductive needle member 14. The closely wound section 15a extends downwardly to a point where it slightly overlaps with the upper end of the stem portion 14c as seen in the drawing in the inoperative state illustrated in Figure 6. The compression coil spring 15 disposed in this fashion is provided with a coil end (lower end as seen in the drawing) fixedly attached to a boss portion 14d of the conductive needle member 14 formed adjacent to the large diameter portion 14b and another coil end (upper end as seen in the drawing) corresponding to the closely wound section 15a received in a recess formed in a part of the electric conductive path 16a of the relay board 16 facing the support hole 13 and abutting the bottom surface of the recess. To allow axial deformation of the compression coil spring 15 in a smooth manner, the inner diameter of the compression coil spring 15 is slightly larger than the outer diameter of the stem portion 14c.

The conductive needle member 14 may also be gold plated added with silver or otherwise surface processed (such as rhodium plating) not only at the head 14a but also over the entire surface. Alternatively, the conductive needle member 14 may be made of material (such as precious metal alloys and copper alloys) having a favorable electric property so as not to adversely affect the electric signal, and only the head may be subjected to the gold plating added with silver. The compression coil spring 15 is typically made of conductive material having a spring property such as steel, but may also be surface processed as mentioned above.

When actually carrying out a test by using such a conductive needle member 14, the holder consisting of the insulating plate member 12 is lowered onto the object to be tested 17, and with the pointed end of each head 14a caused to abut the corresponding pad 17a and the compression coil spring 15 compressed, the conductive needle member 14 is brought into contact with the pad 17a with an adequate loading which enables it to penetrate an oxide film that may be formed on the surface of the pad 17a. At this time, if there is any solder W deposited on the surface of the pad 17a during a preceding processing step, a part of the solder W may adhere to the head 14a as a result of such a contact. However, because the head 14a is formed with a gold plate layer mixed with silver which prohibits solder deposition, it is possible to favorably avoid the transfer of solder from the objects to be tested which the head 14a is brought into contact with.

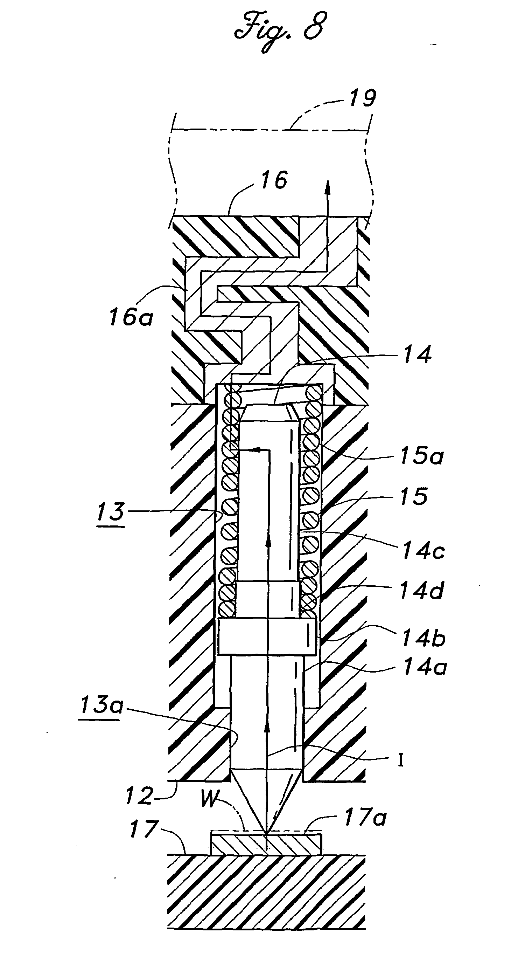

During a test process, an electric signal flows from the pad 17a to the electric conductive path 16a via the conductive needle member 14 and the compression coil spring 15 as indicated by the arrow I shown in Figure 8. Because the inner diameter of the compression coil spring 15 is slightly larger than the outer diameter of the stem portion 14c, the compression of the coil spring 15 causes it to meander or curve like a snake within the support hole 13 so that the inner circumference of the closely wound section 15a engages the outer circumferential surface of the stem portion 14c.

Because the closely wound section 15a consists of mutually contacting turns of the coil wire, the electric signal which is transmitted from the conductive needle member 14 to the compression coil spring 15 is allowed to flow along the axial direction of the compression coil spring as shown in Figure 8, instead of flowing along a spiral path defined by the coil wire of coarsely wound turns, so that the electric inductance and resistance are minimized. Furthermore, the lower end of the compression coil spring 15 is wrapped around the boss portion 14d, and this provides an alternate or parallel electric path with respect to the electric path defined along the stem portion 14c. This also contributes to a stable and low resistance transmission of signals by the contact probe head.

In the inoperative state illustrated in Figure 6, the free end of the stem portion 14c slightly overlaps with the closely wound section 15a. It is also possible to have them overlap each other over a greater length, or to do away with such an overlapping. At any event, as soon as the conductive needle member 14 is brought into contact with the pad 17a, and is caused to retract slightly, the stem portion 14c is brought into contact with the closely wound section 15a so that the closely wound section 15a is brought into contact with the conductive needle member 14 without fail without regard to the variations in the height of the point to be contacted and the variations in the compressive deformation of the compression coil spring 15 for each conductive needle member 14.

In the foregoing embodiment, the free end of each conductive needle member consisted of a pointed conical end, but may also consist of a flat end as illustrated in Figure 9 if the object to be contacted consists of a solder ball 7a or the like. In this case, a gold plate layer added with silver 18' is formed over the surface of a cylindrical end portion of the head 14a' of a conductive contact member 14, and the end surface engages the solder ball 7a via the gold layer added with silver 18'.

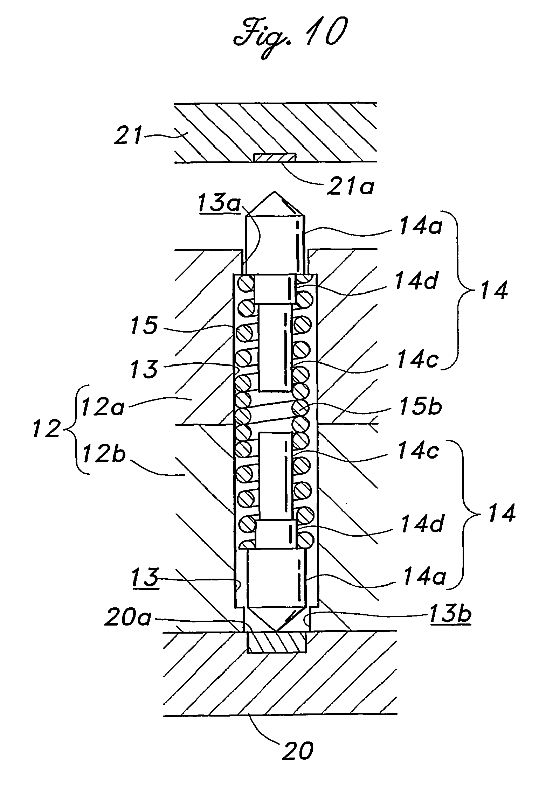

The conducive contact member embodying the present invention is not limited to those illustrated above. A third embodiment of the present invention is described in the following with reference to Figure 10. In this embodiment, the parts corresponding to those of the previous embodiments are denoted with like numerals without repeating the description of such parts.

The conductive needle members 14 illustrated in Figure 10 are not provided with a part corresponding to the large diameter portion 14b of the previous embodiment, but is otherwise similar to the same. An end of a compression coil spring 15 is connected to the conductive needle member 14 by being wrapped around a boss portion 14d of the corresponding conductive needle member 14, and the other coil end is similarly connected to an identical and coaxially disposed conductive needle member 14 so as to form a contact probe head having a pair of moveable ends. The heads 14a of these conductive needle members 14 thus face away from each other.

The holder 12 for defining a support hole 13 to receive the compression coil spring 15 and support the two conductive needle members 14 is formed by placing a pair of plastic plate members 12a and 12b one over the other. The upper and lower surfaces of the plate members 12a and 12b as seen in the drawing are each formed with a small diameter hole 13a, 13b which is more reduced in diameter than the remaining part of the support hole 13 but can slidably receive the cylindrical part of the corresponding head 14a. There is a gap between the cylindrical part of each head 14a and the corresponding small diameter hole 13a, 13b in the drawing, but it only means that the inner diameter of the small diameter hole 13a, 13b is greater than the outer diameter of the cylindrical part of the head 14a, and the proportions of various parts do not necessary correspond to those of the actual device. The same is true with the previous embodiments. In this embodiment, each conductive needle member 14 is prevented from coming off from the support hole 13 by the outer peripheral part of the compression coil spring 15 wrapped around the boss portion 14d engaging the shoulder defined between the support hole 13 and the corresponding small diameter hole 13a, 13b.

In the embodiment illustrated in Figure 10, a circuit board 20 such as a burn-in board is provided in a lower part as seen in the drawing, and one of the conductive needle members 14 is brought into contact with a circuit pattern 20a which is formed so as to be flush with the remaining surface of the circuit board 20. When conducting a test, the contact probe head is moved toward the object to be tested 21 shown in an upper part of the drawing, and the other conductive needle member 14 is resiliently brought into contact with a test pad 21a of the object to be tested 21. During the test, both of the conductive needle members 14 are in a similar state to that of the lower conductive needle member 14 shown in the drawing.

In this case also, during the test, the electric signal is conducted from the test pad 21a to the upper conductive needle member 14, and is further conducted from the stem portion 14c of the upper conductive needle member 14 to the stem portion 14c of the lower conductive needle member 14 via the closely wound section 15b provided in an intermediate portion of the compression coil spring 15 before the electric signal is finally conducted from the lower conductive needle member 14 to the circuit pattern 20a. In this embodiment also, the conductive path passes through the closely wound section 15b of the compression coil spring 15, and extends linearly along the axial direction of the compression coil spring 15. Therefore, the increase in the electric inductance and resistance due to the high frequency signal flowing through a coarsely wound section along a spiral path can be avoided, and the electric inductance and resistance can be reduced. This embodiment allows the overall length of the assembly to be reduced at least by the length of the large diameter portion 14b, and such a simplification of the shape of the conductive needle member 14 contributes to the reduction in the component cost.

In the embodiment illustrated in Figure 10 also, the head 14a of the conductive needle member 14 is subjected to a gold plating added with silver in a similar way as the previous embodiments. Because the head 14a is provided with a gold plate layer added with silver which is resistant to solder deposition, deposition of solder onto the head 14a can be avoided even after a repeated contacts with the objects to be tested.

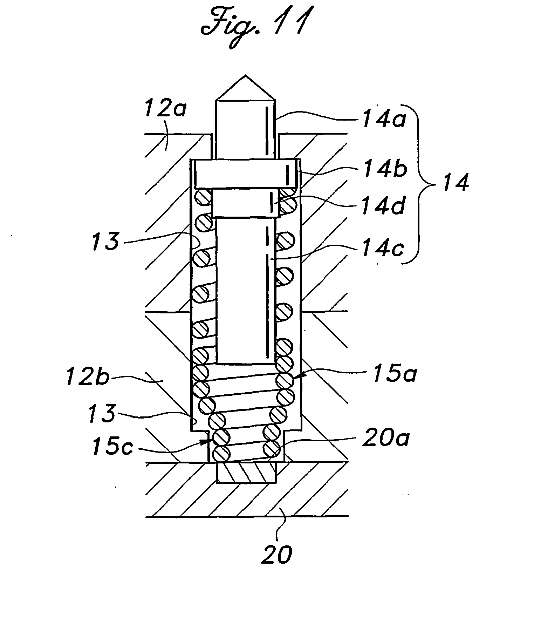

According to the present invention, a fourth embodiment as illustrated in Figure 11 is also possible. In Figure 11, the parts corresponding to those of the previous embodiment are denoted with like numerals without repeating the description of such parts. According to the embodiment illustrated in Figure 11, only one conductive needle member 14 is used as opposed to the embodiment illustrated in Figure 10 having two moveable ends, and a coil end of a compression coil spring 15 is used as a conductive contact member instead. As illustrated in Figure 11, the coil end of the compression coil spring 15 which is not associated with a separate conductive needle member is provided with a closely wound section 15a which includes a straight section adjacent to the coarsely wound section or the main section of the compression coil spring and having about the same diameter as the main section, a tapered section having a larger end connected to the straight section, and a straight small diameter section 15c connected to the smaller end of the tapered section.

Therefore, according to the embodiment illustrated in Figure 11, the straight small diameter section 15c is brought into contact with the circuit pattern 20a.

The compression coil spring 15 is closely wound from a point slightly overlapping with the stem portion 14c of the conductive needle member 14 to the outer end defined by the straight small diameter section 15c.

In Figure 11 also, the closely would section 15a of the compression coil spring 15 is in contact with the stem portion 14c of the upper electrically conductive needle member 14 so that the electric signal conducted to the conductive needle member 14 passes through the closely wound section 15a. Therefore, the electric signal is conducted axially along the compression coil spring 15, and the increase in electric inductance and resistance due to the flow of the high frequency signal along a spiral path can be avoided.

In the embodiment illustrated in Figure 11 also, the head 14a of the conductive needle member 14 is subjected to a gold plating added with silver in a similar way as the previous embodiments. Because the head 14a is provided with a gold plate layer added with silver which is resistant to solder deposition, deposition of solder onto the head 14a can be avoided even after repeated contacts with the objects to be tested.

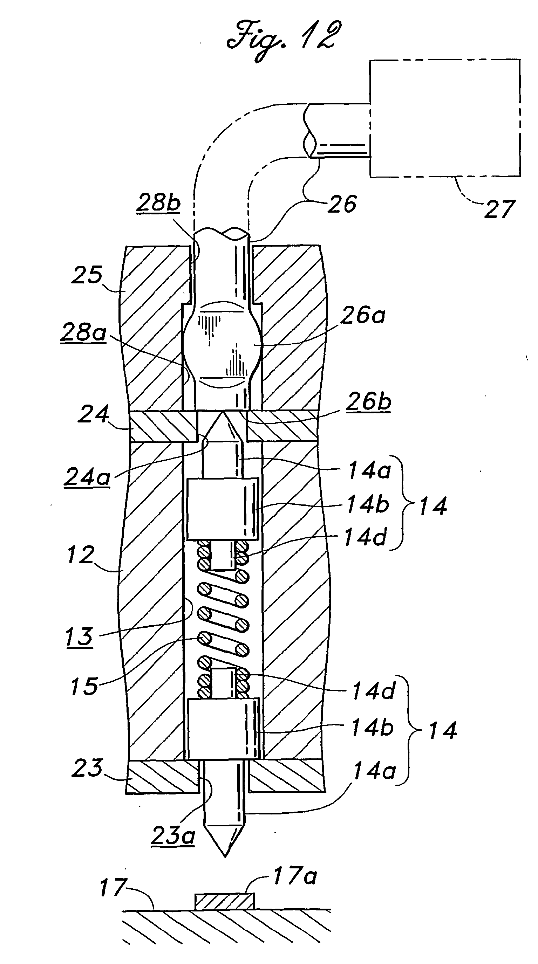

According to the present invention, a fifth embodiment as illustrated in Figure 12 is also possible. In Figure 12, the parts corresponding to those of the previous embodiment are denoted with like numerals without repeating the description of such parts. According to the embodiment illustrated in Figure 12, the contact probe is provided with two moveable ends similarly as the embodiment of Figure 10, but the stem portion 14c is omitted from each conductive needle member 14.

The holder comprises a main body consisting of a middle plate member 12, and an upper and lower plate member 23 and 24 integrally attached to an upper and lower surface of the middle plate member. The middle plate member 12 is formed with a straight hole serving as a main part of the support hole 13. The upper and lower plate members 23 and 24 are each provided with small diameter holes 23a and 24a, respective, both coaxially aligned with the main support hole 13. A compression coil spring 15 is received in the main support hole 13. Each conductive needle member 14 comprises a head 14a projecting out of the corresponding small diameter hole 23a, 24a, a large diameter portion 14b formed at the inner end of the head 14a, and a boss portion 14d extending from a rear end or inner end of the large diameter portion 14b and having a smaller diameter than the large diameter portion 14b. The conductive needle members 14 are each retained in the support hole by the annular shoulder defined between the main support hole 13 and the corresponding small diameter hole 23a, 24a engaging the annular shoulder defined on the outer end of the large diameter portion 14b. The head 14a of each conductive needle member 14 is slidably supported by the small diameter hole 23a, 23b provided in the corresponding one of the upper and lower plate members 23 and 24.

A wiring plate 25 is placed over the upper surface of the upper plate member 24 at the top end of the holder as seen in the drawing, and is provided with a through hole 28 aligned coaxially with the holder hole 13. The through hole 28 includes a retaining hole 28a having a relatively large diameter and opposing the small diameter hole 24a, and a lead wire guide hole 28b having a relatively small diameter and facing away from the small diameter hole 24a. The retaining hole 28a receives a disk-shaped flattened portion 26a formed in an end portion of a lead wire 26 consisting of enameled wire or other single solid wire serving as a signal transmission line. This flattened portion 26a is formed by pressing an end portion of the lead wire 26 from a lateral direction or otherwise causing a plastic deformation, and is substantially formed into a disk shape defining a larger diameter than that of the lead wire 26 (the outer diameter of the enameled wire).

The lead wire 26 is lead outward via the lead wire guide hole 28b having a relatively small diameter and extending through the wiring plate 25 from the retaining hole 28a in a continuous manner, and is connected to an external circuit 27 which may consist of a measuring instrument. The lead wire guide hole 28b is dimensioned so as to restrict the passage of the flattened portion 26a but allow the passage of the remaining part of the lead wire 26. Therefore, the flattened portion 26a received in the retaining hole 28a is prevented from being pulled out of the retaining hole 28a by being engaged by the shoulder defined between the retaining hole 28a and lead wire guide hole 28b.

The axial end surface 26b of the lead wire 26 having the flattened portion 26a retained in the retaining hole 28a is located inside the retaining hole 28a so as to directly face the small diameter hole 24a, and allow the head 14a of the conductive needle member 14 to resiliently engage the end surface 26b of the lead wire 26.

In the embodiment illustrated in Figure 12 also, the head 14a of the conductive needle member 14 is subjected to a gold plating added with silver in a similar way as the previous embodiments. Because the head 14a is provided with a gold plate layer added with silver which is resistant to solder deposition, deposition of solder onto the head 14a can be avoided even after a repeated contacts with the objects to be tested.

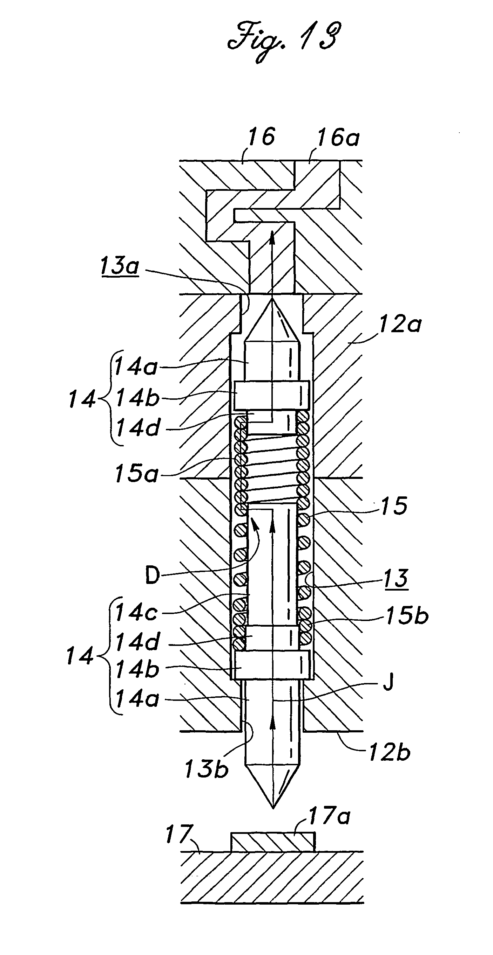

According to the present invention, a sixth embodiment as illustrated in Figure 13 is also possible. In Figure 13, the parts corresponding to those of the previous embodiment are denoted with like numerals without repeating the description of such parts. According to the embodiment illustrated in Figure 13, the contact probe head is provided with two moveable ends similarly as the embodiment of Figure 10, and the lower conductive needle member 14 as seen in the drawing is similar to that of Figure 6 while the upper conductive needle member 14 as seen in the drawing does away with the stem portion 14c. The holder for retaining the conductive needle members 14 and compression coil spring 15 in this case is formed by placing two plate members 12a and 12b one over the other similarly as the embodiment illustrated in Figure 6, and is provided with a support hole 13 passed across the thickness of the two mutually overlaid plate members 12a and 12b. The support hole 13 comprises small diameter holes 13a and 13b formed at the upper and lower surfaces, respectively, and given with a smaller diameter than the support hole 13.

The two conductive needle members 14 are connected to the two ends of the compression coil spring 15 in a similar manner as those shown in Figure 6, but the upper closely wound section 15a corresponding the upper conductive needle member 14 is longer than the axial length of the boss portion 14b while the lower closely wound section 15b consists of a few turns of the coil wire so as to wrap around the corresponding boss portion 14d. The compression coil spring 15 and large diameter portions 14b of the two conductive needle members 14 are received in the support hole 13, and the conductive needle members 14 are each prevented from coming off by the large diameter portion 14b engaged by the shoulder defined between the support hole 13 and small diameter hole 13a, 13b.

On the upper surface of the upper plate member 12a as seen in the drawing is placed a relay board 16 forming signal exchanging means for relaying the electric signal similarly as the embodiment illustrated in Figure 6. The surface of an electric conductive path 16a formed in the relay board 16 facing the small diameter hole 13a is required to contact the pointed end of the head 14a of the conductive needle member 14, and is therefore formed flush with the lower surface (interface with respect to the base board element 12a) of the relay board 16 as seen in the drawing.

According to the embodiment illustrated in Figure 13, in the inoperative state illustrated in Figure 13, the extreme end (lower end in the drawing) of the upper closely wound section 15a engages the upper end of the stem portion 14c of the lower conductive needle member 14 as seen in the drawing. Therefore, when the lower conductive needle member 14 comes into contact with the pad 17a, there is only one point of sliding contact D between the compression coil spring 15 and each conductive needle member 14 as indicated by the arrow J showing the electric signal flow, and the fluctuation in the electric resistance of the conductive path can be minimized. Also, the electric signal is not required to flow along a spiral path.

In the embodiment illustrated in Figure 13 also, the head 14a of the conductive needle member 14 is subjected to a gold plating added with silver in a similar way as the previous embodiments. Because the head 14a is provided with a gold plate layer added with silver which is resistant to solder deposition, deposition of solder onto the head 14a can be avoided even after repeated contacts with the objects to be tested.

The silver content was 0.01% to 8% in the above described embodiments, but is more preferably 2% to 6% in the case of a conductive contact member in the form of a coil spring, and 0.5% to 2% in the case of a conductive contact member in the form of a needle member.

According to the present invention, in applications such as fixtures for testing semiconductor devices and circuit boards having solder balls or terminals having solder deposited thereon, and electric sockets for semiconductor device, transfer of solder from the object to be tested onto the conductive contact member can be reduced, and the number of possible contacts that can be effected before the cleaning of the solder deposition becomes necessary can be increased. Therefore, the run time of the test line can be increased, and the maintenance cost can be reduced.

Although the present invention has been described in terms of preferred embodiments thereof, it is obvious to a person skilled in the art that various alterations and modifications are possible without departing from the scope of the present invention which is set forth in the appended claims.

## Claims

1. A conductive contact member (3, 14) for establishing an electric contact by being applied to an object to be contacted, comprising a layer (8a; 8b; 18; 18') of highly electrically conductive material resistant to solder deposition formed at least over a conductive contact part of said conductive contact member (14), **characterized in that** said highly electrically conductive material consists of gold added with 0,01 % to 8 % of silver.

2. A conductive contact member according to claim 1, wherein said layer (8a; 8b; 18; 18') is formed by plating.

3. A conductive contact member according to claim 1, wherein said conductive contact member is in the form of a member of a group consisting of a coil (3), needle member (14) having a pointed end, and rod member having a flat end.

4. A conductive contact member according to claim 1, wherein said conductive contact member (14) is made of steel.

5. A conductive contact member according to claim 1, wherein said conductive contact member is in the form of a compression coil spring (3), and said solder deposition resistant layer deposition (8a; 8b) is formed around a coil wire forming said coil spring.

6. A conductive contact member according to claim 1, wherein said conductive contact member is in the form of a compression coil spring (3) having a contact part consisting of closely wound turns of a coil wire (3a), and said solder deposition resistant layer (8a; 8b) is formed over an outer surface of said closely wound turns of the coil wire (3a).

## Patentansprüche

1. Leitendes Kontaktelement (3, 14) zur Erstellung eines elektrischen Kontakts durch Angelegtwerden an ein zu kontaktierendes Objekt, mit einer Schicht (8a ; 8b ; 18 ; 18') aus elektrisch hochleitendem Material, das gegen Lötmetallablagerung beständig ist, welche wenigstens über einem leitenden Kontaktteil des leitenden Kontaktelements (14) gebildet ist, **dadurch gekennzeichnet, dass** das elektrisch hochleitende Material aus Gold mit 0,01% bis 8% Silberzusatz besteht.

2. Leitendes Kontaktelement gemäß Anspruch 1, wobei die Schicht (8a ; 8b ; 18 ; 18') durch Plattieren geformt ist.

3. Leitendes Kontaktelement gemäß Anspruch 1, wobei das leitende Kontaktelement in Form eines Elements einer Gruppe, bestehend aus einer Spirale (3), einem Nadelelement (14) mit einem zugespitzten Ende und einem Stabelement mit einem flachen Ende, vorliegt.

4. Leitendes Kontaktelement gemäß Anspruch 1, wobei das leitende Kontaktelement (14) aus Stahl hergestellt ist.

5. Leitendes Kontaktelement gemäß Anspruch 1, wobei das leitende Kontaktelement in Form einer Spiraldruckfeder (3) vorliegt und die lötmetallablagerungsbeständige Schicht (8a ; 8b) um einen Spiraldraht, der die Spiralfeder bildet, herum geformt ist.

6. Leitendes Kontaktelement gemäß Anspruch 1, wobei das leitende Kontaktelement in Form einer Spiraldruckfeder (3) vorliegt, welche einen aus eng gewickelten Windungen eines Spiraldrahts (3a) bestehenden Kontaktteil aufweist, und die lötmetallablagerungsbeständige Schicht (8a ; 8b) über einer Außenfläche der eng gewickelten Windungen des Spiraldrahts (3a) gebildet ist.

## Revendications

1. Membre de contact conducteur (3, 14) pour établir un contact électrique par application à un objet avec lequel un contact doit être établi, comprenant une couche (8a ; 8b ; 18 ; 18') d'un matériau fortement électroconducteur résistant à un dépôt de matière d'apport de brasage formée au moins par-dessus une partie de contact conductrice dudit membre de contact conducteur (14), **caractérisé en ce que** ledit matériau fortement électroconducteur est constitué d'or additionné d'argent à concurrence de 0,01 % à 8 %.

2. Membre de contact conducteur selon la revendication 1, dans lequel ladite couche (8a ; 8b ; 18 ; 18') est formée par placage.

3. Membre de contact conducteur selon la revendication 1, dans lequel ledit membre de contact conducteur se présente sous la forme d'un membre choisi parmi le groupe constitué par un enroulement (3), un membre (14) de forme aciculaire possédant une extrémité pointue et un membre en forme de tige possédant une extrémité plate.

4. Membre de contact conducteur selon la revendication 1, dans lequel ledit membre de contact conducteur (14) est réalisé en acier.

5. Membre de contact conducteur selon la revendication 1, dans lequel ledit membre de contact conducteur se présente sous la forme d'un ressort de compression hélicoïdal (3), et ladite couche résistant à un dépôt de matière d'apport de brasage (8a ; 8b) est formée autour d'un fil métallique en spirale formant ledit ressort hélicoïdal.

6. Membre de contact conducteur selon la revendication 1, dans lequel ledit membre de contact conducteur se présente sous la forme d'un ressort de compression à enroulement (3) possédant une partie de contact constituée par des spires étroitement enroulées d'un fil métallique en spirale (3a) et ladite couche résistant à un dépôt de matière d'apport de brasage (8a ; 8b) est formée par dessus la surface externe desdites spires étroitement enroulées du fil métallique en spirale (3a).

*Fig. 1*

Fig. 2

Fig. 3

Fig. 4

Fig. 5

*Fig. 6*

*Fig. 7*

14a

14

18

*Fig. 9*

14a'

18'

7a

7

## Fig. 8

*Fig. 10*

## Fig. 11

## *Fig. 12*

# Fig. 13